# EUROPEAN PATENT APPLICATION

(11) **EP 3 407 366 A1**
(43) Date of publication of application: **28.11.2018**
(21) Application number: 18173798.2
(22) Date of filing: 23.05.2018
(51) Int. Cl.: H01F 27/28, H02J 50/10

(54) **INTEGRATED SYSTEM FOR SIGNAL AND POWER TRANSMISSION WITH GALVANIC ISOLATION**

(30) Priority: 24.05.2017 CN 201710373963
(71) Applicant: General Electric Company, Schenectady, NY 12345 (US)
(72) Inventor: MAO, Saijun, Pudong, Shanghai 201203 (CN); QU, Bo, Pudong, Shanghai 201203 (CN); SHI, Jingkui, Pudong, Shanghai 201203 (CN); XU, He, Pudong, Shanghai 201203 (CN); SHEN, Jie, Niskayuna, NY 12309 (US); SONG, Tingting, Pudong, Shanghai 201203 (CN); YUAN, Zhihui, Niskayuna, NY New York 12309 (US); JIANG, Xin, Pudong, Shanghai 201203 (CN); LU, Xi, Pudong, Shanghai 201203 (CN); SCHROEDER, Stefan, Niskayuna, NY 12309 (US); MECHLINSKI, Marius Michael, 85748 Garching (DE)
(74) Representative: Fischer, Michael Maria

(57) **Abstract**

An integrated system (100) for signal and power transmission with galvanic isolation is disclosed. The integrated system (100) comprises an insulative layer (101) having a primary side (111) and a secondary side (112); a planar signal transformer (130) and a planar power transformer(150) for signal and power transmission between the primary and the secondary sides (111,112) of the insulative layer (101) respectively. The planar signal transformer (130) comprises two signal coupling elements (131, 133) which are disposed on the primary and the secondary sides of the insulative layer respectively. The planar power transformer (150) includes two power coupling elements (151, 153) which are disposed on the primary and the secondary sides of the insulative layer respectively. Each of the two signal coupling elements (131,133) and the two power coupling elements (151,153) is embedded in at least one layer (103,104) of a multi-layer printed circuit board. The integrated system (100) of the present disclosure has a compact structure and is suitable for automatic assembly and manufacturing.

## Description

### BACKGROUND

The present disclosure generally relates to an integrated system for signal and power transmission with galvanic isolation.

Transformers are often used to transfer signal or power between circuits that are operating at different voltages. In many circuit arrangements, a signal or power needs to be transmitted between two circuits that must otherwise be electrically isolated from one another. For example, the transmitting circuit could utilize high internal voltages that would present a hazard to the receiving circuit or individuals in contact with that circuit.

Either signal transformer or power transformer with galvanic isolation can be achieved by using the characteristics of a magnetic field, an electrical field, an electromagnetic field, or by mechanical coupling (with piezoelectric ceramics). In some cases, the circuit must provide both signal and power isolation across an insulating barrier. For example, both signal and power isolation are needed in a gate driver circuit for power semiconductor devices such as insulated-gate bipolar transistor (IGBT), metal-oxide-semiconductor field-effect transistor (MOSFET). Therefore, an integrated system for signal and power transmission with galvanic isolation is required to realize a compact structure.

### BRIEF DESCRIPTION

One aspect of the present disclosure provides an integrated system for signal and power transmission with galvanic isolation. The integrated system comprises an insulative layer having a primary side and a secondary side; a planar signal transformer and a planar power transformer for signal and power transmission between the primary and the secondary sides of the insulative layer respectively. The planar signal transformer comprises two signal coupling elements which are disposed on the primary and the secondary sides of the insulative layer respectively. The planar power transformer includes two power coupling elements which are disposed on the primary and the secondary sides of the insulative layer respectively. Each of the two signal coupling elements and the two power coupling elements is embedded in at least one layer of a multi-layer printed circuit board (PCB).

The integrated system of the present disclosure can realize both signal and power transmission based on the multi-layer PCB with high voltage galvanic isolation. Besides that, the integrated system also has the following advantages. At first, it eliminates the use of conventional optic fiber for signal isolation, so the integrated system of the present disclosure may have improved long term reliability. Secondly, it provides a compact structure with planar signal transformer and planar power transformer based on the multi-layer PCB. Thirdly, it also enables automatic assembly of a circuit including the integrated signal and power transmission system, so the manufacturing cost may be reduced.

### BRIEF DESCRIPTION OF THE DRAWINGS

The above and other aspects, features, and advantages of the present disclosure will become more apparent in light of the subsequent detailed description when taken in conjunction with the accompanying drawings in which:
Fig. 1 is a side view of an integrated system for signal and power transmission with galvanic isolation in accordance with a first embodiment of the present disclosure;
Fig. 2 is a top view of the layer 103 in Fig. 1 in accordance with an embodiment of the present disclosure;
Fig. 3 is a top view of the layer 103 in Fig. 1 in accordance with another embodiment of the present disclosure;
Fig. 4 is a side view of an integrated system for signal and power transmission with galvanic isolation in accordance with a second embodiment of the present disclosure;
Fig. 5 is a side view of an integrated system for signal and power transmission with galvanic isolation in accordance with a third embodiment of the present disclosure;
Fig. 6 is a side view of an integrated system for signal and power transmission with galvanic isolation in accordance with a fourth embodiment of the present disclosure; and
Fig. 7 is a schematic drawing of a power semiconductor device gate driver circuit in accordance with one embodiment of the present disclosure.

### DETAILED DESCRIPTION

Unless defined otherwise, technical and scientific terms used herein have the same meaning as is commonly understood by one of skill in the art to which this invention belongs. The terms "a" and "an" do not denote a limitation of quantity, but rather denote the presence of at least one of the referenced items. Approximating language, as used herein throughout the specification and claims, may be applied to modify any quantitative representation that could permissibly vary without resulting in a change in the basic function to which it is related. Accordingly, a value modified by a term or terms, such as "about" and "substantially", are not to be limited to the precise value specified. Additionally, when using an expression of "about a first value - a second value," the about is intended to modify both values. In at least some instances, the approximating language may correspond to the precision of an instrument for measuring the value. Here, and throughout the specification and claims, range limitations may be combined and/or interchanged, such ranges are identified and include all the sub-ranges contained therein unless context or language indicates otherwise. Moreover, the suffix "(s)" as used herein is usually intended to include both the singular and the plural of the term that it modifies, thereby including one or more of that term.

Any numerical values recited herein include all values from the lower value to the upper value in increments of one unit provided that there is a separation of at least 2 units between any lower value and any higher value. As an example, if it is stated that the amount of a component or a value of a process variable such as, for example, temperature, pressure, time and the like is, for example, from 1 to 90, it is intended that values such as 15 to 85, 22 to 68, 43 to 51, 30 to 32 etc. are expressly enumerated in this specification. For values which are less than one, one unit is considered to be 0.0001, 0.001, 0.01 or 0.1 as appropriate. These are only examples of what is specifically intended and all possible combinations of numerical values between the lowest value and the highest value enumerated are to be considered to be expressly stated in this application in a similar manner.

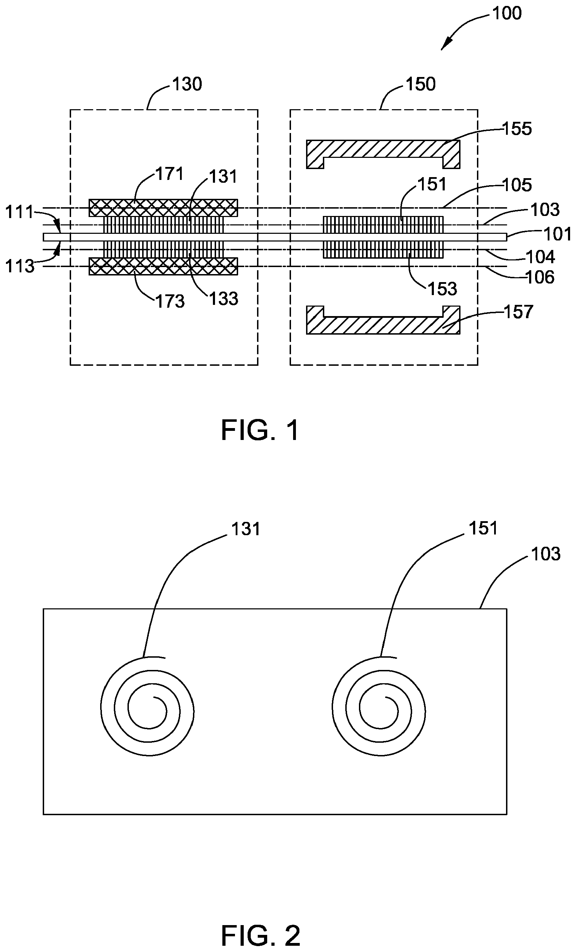

Fig. 1 shows an integrated system 100 for signal and power transmission with galvanic isolation in accordance with a first embodiment of the present disclosure. As shown in Fig. 1, the integrated system 100 comprises an insulative layer 101, a planar signal transformer 130 and aplanar power transformer 150. The planar signal transformer 130 and the planar power transformer 150 share the common insulative layer 101. The insulative layer 101 has two opposite sides called as a primary side 111 and a secondary side 113. The planar signal transformer 130 and the planar power transformer 150 are used for signal transmission and power transmission between the primary and the secondary sides 111, 113 of the insulative layer 101 respectively.

The planar signal transformer 130 comprises a primary winding 131 and a secondary winding 133 which are disposed on the primary and the secondary sides 111, 113 of the insulative layer 101 respectively. The primary winding 131 and the secondary winding 133 are respectively embedded in two different layers 103, 104 of a multi-layer PCB. As a pair of inductive coupling elements, the primary winding 131 and the secondary winding 133 are configured to generate a magnetic field across the insulative layer 101 for signal transmission.

The planar power transformer 150 comprises a primary winding 151 and a secondary winding 153 which are disposed on the primary and the secondary sides 111, 113 of the insulative layer 101 respectively. The primary winding 151 and the secondary winding 153 are also in the two different layers 103, 104 of the multi-layer PCB. The primary winding 151 and the secondary winding 153 are configured to generate a magnetic field across the insulative layer 101 for power transmission. The planar power transformer 150 may further comprise a pair of magnetic cores 155, 157. The pair of magnetic cores 155, 157 are disposed on the primary and the secondary sides 111, 113 of the insulative layer 101 respectively to cover the primary winding 151 and the secondary winding 153. To be more specific, the primary winding 151 and the secondary winding 153 are disposed between the pair of magnetic cores 155, 157. Usually, the magnetic cores 155, 157 are made of ferrite materials, and each of them may be in any appropriate shape, such as flat-plate shape.

In some embodiments, the integrated system 100 may further comprise two electromagnetic shielding plates 171, 173. The two electromagnetic shielding plates 171, 173 are disposed on the primary and the secondary sides 111, 113 of the insulative layer 101 respectively to cover the primary winding 131 and the secondary winding 133, as shown in Fig. 1, so as to inhibit the magnetic field generated by the primary winding 131 and the secondary winding 133 from extending beyond the planar signal transformer 130. The electromagnetic interference (EMI) during signal transmission can be eliminated. Preferably, the two electromagnetic shielding plates 171, 173 are in another two different layers 105, 106 of the multi-layer PCB. Each of the electromagnetic shielding plates 171, 173 may comprise an electromagnetic shielding material, such as copper.

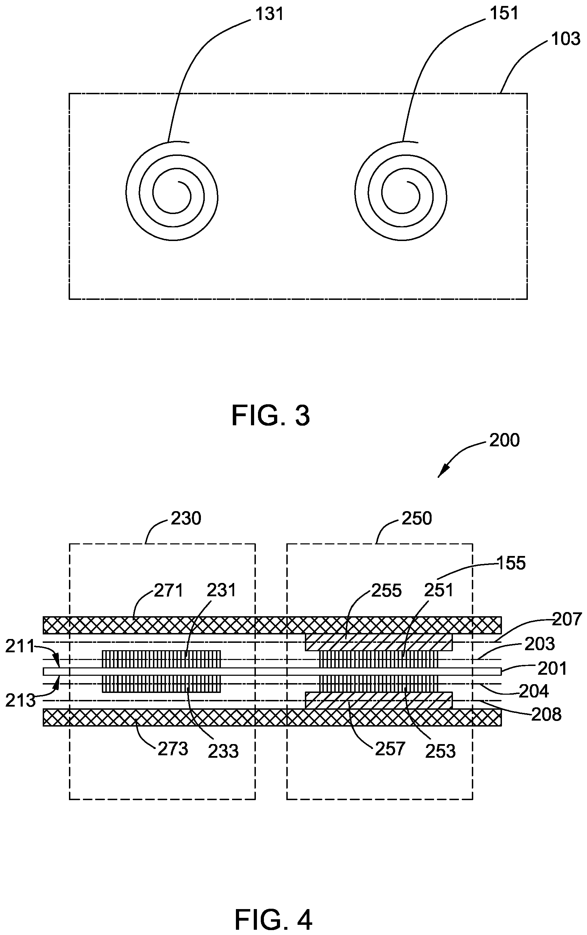

About these layers 103, 104, 105, 106 of the multi-layer PCB, in some embodiments, they may be the same shape dimension, and each may have a uniform thickness with windings or electromagnetic shielding material embedded in it. Fig. 2 shows a top view of the layer 103. Both the primary winding 131 of the planar signal transformer 130 and the primary winding 151 of the planar power transformer 150 are embedded in the layer 103. The parts without windings of the layer 103 may be filled with an insulative material. While in some other embodiments, at least one of the layers 103, 104, 105, 106 of the multi-layer PCB may be discontinuous. For example, as shown in Fig. 3, the layer 103 is a plane where the primary winding 131 and the primary winding 151 are placed. The layer 103 is not a continuous plate.

In the integrated system 100, the primary winding 131 and the primary winding 151 are in a same layer 103 of the multi-layer PCB. The secondary winding 133 and the secondary winding 153 are also in a same layer 104. In some embodiments, the primary winding 131 and the primary winding 151 may be embedded in two different layers of the multi-layer PCB. And the secondary winding 133 and the secondary winding 153 may be also embedded in two different layers of the multi-layer PCB.

Fig. 4 shows an integrated system 200 for signal and power transmission with galvanic isolation in accordance with a second embodiment of the present disclosure. As shown in Fig. 4, the integrated system 200 has a similar structure to the integrated system 100 shown in Fig. 1. The integrated system 200 comprises an insulative layer 201, a planar signal transformer 230 and a planar power transformer 250. The planar signal transformer 230 comprises a primary winding 231 and a secondary winding 233 which are disposed on a primary side 211 and a secondary side 213 of the insulative layer 201 respectively for signal transmission. The planar power transformer 250 comprises a primary winding 251 and a secondary winding 253, which are disposed on the primary side 211 and the secondary side 213 of the insulative layer 201 respectively for power transmission. The primary winding 231 and the primary winding 251 are embedded in a layer 203 of a multi-layer PCB. The secondary winding 233 and the secondary winding 253 are embedded in another layer 204 of the multi-layer PCB.

The integrated system 200 may further comprise two electromagnetic shielding plates 271, 273 which can cover both the planar signal transformer 230 and the planar power transformer 250, to eliminate EMI during signal and/or power transmission. The two electromagnetic shielding plates 271, 273 may be embedded in two different layers of the multi-layer PCB.

The integrated system 200 may further comprise two planar magnetic cores 255, 257, which are also embedded in two different layers 207, 208 of the multi-layer PCB. Therefore, the integrated system 200 has more compact structure than the integrated system 100.

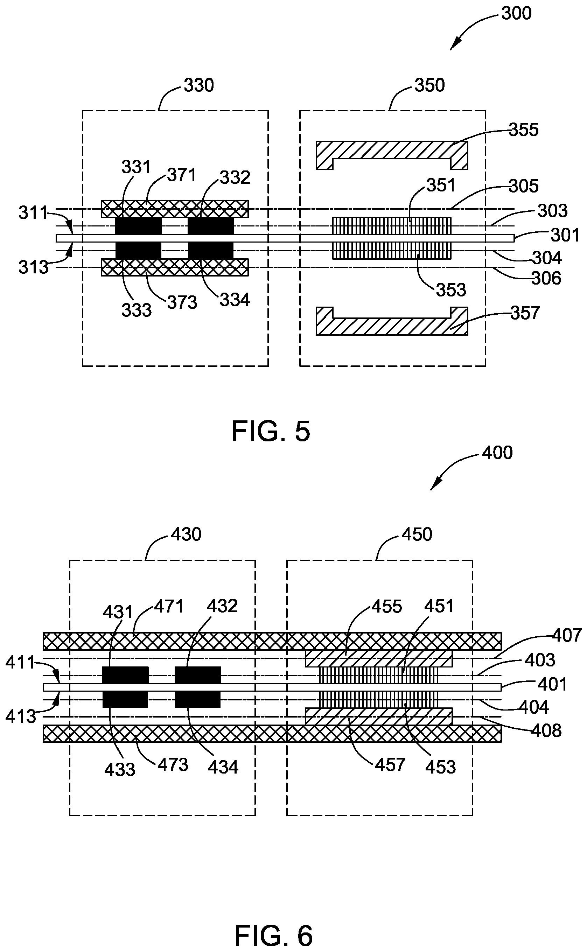

Fig. 5 shows an integrated system 300 for signal and power transmission with galvanic isolation in accordance with a third embodiment of the present disclosure. As shown in Fig. 5, the integrated system 300 comprises an insulative layer 301, a planar signal transformer 330 and a planar power transformer 350. The insulative layer 301 has a primary side 311 and a secondary side 313. The planar signal transformer 330 and the planar power transformer 350 are used for signal transmission and power transmission between the primary and the secondary sides 311, 313 of the insulative layer 301 respectively.

Different from the planar signal transformer 130 of the integrated system 100 shown in Fig. 1 and the planar signal transformer 230 of the integrated system 200 shown in Fig. 4, the planar signal transformer 330 of the integrated system 300 comprises capacitive coupling elements: a first plate capacitor 331, 333 and a second plate capacitor 332, 334. The plate 331 of the first plate capacitor and the plate 332 of the second plate capacitor are disposed on a primary side 311 of the insulative layer 301, and embedded in a layer 303 of a multi-layer PCB. The plate 333 of the first plate capacitor and the plate 334 of the second plate capacitor are disposed on a secondary side 313 of the insulative layer 301, and embedded in a layer 304 of the multi-layer PCB. The first plate capacitor 331, 332 and the second plate capacitor 333, 334 are configured to generate an electric field through capacitive coupling for signal transmission between the primary and the secondary sides 311, 313 of the insulative layer 301.

The planar power transformer 350 has a same structure to the planar power transformer 150 of the integrated system 100 in Fig. 1. The planar power transformer 350 comprises a primary winding 351 and a secondary winding 353, which are disposed on the primary side 311 and the secondary side 313 of the insulative layer 301 respectively for power transmission. The primary winding 351 and the secondary winding 353 are respectively embedded in two layers 303, 304 of the multi-layer PCB. The planar power transformer 350 may also comprise two magnetic cores 355, 357, which are disposed on the primary and the secondary sides 311, 313 of the insulative layer 301 respectively, to cover the primary winding 351 and the secondary winding 353.

In some embodiments, the integrated system 300 may further comprise two electromagnetic shielding plates 371, 373, which are disposed on the primary and the secondary sides 311, 313 of the insulative layer 301 respectively, to cover the first plate capacitor 331, 333 and the second plate capacitor 332, 334, as shown in Fig. 3. Thus the EMI during signal transmission could be eliminated. Preferably, the two electromagnetic shielding plates 371, 373 are embedded in two layers 305, 306 of the multi-layer PCB.

Fig. 6 shows an integrated system 400 for signal and power transmission with galvanic isolation in accordance with a fourth embodiment of the present disclosure. As shown in Fig. 6, the integrated system 400 comprises an insulative layer 401, a planar signal transformer 430 and a planar power transformer 450.

The planar signal transformer 430 has a same structure to the planar signal transformer 330 of the integrated system 300 shown in Fig. 5, and comprises a first plate capacitor 431, 433 and a second plate capacitor 432, 434. The plate 431 of the first plate capacitor and the plate 432 of the second plate capacitor are disposed on a primary side 411 of the insulative layer 401, and embedded in a layer 403 of a multi-layer PCB. The plate 433 of the first plate capacitor and a plate 434 of the second plate capacitor are disposed on a secondary side 413 of the insulative layer 401, and embedded in a layer 404 of the multi-layer PCB. The planar power transformer 450 has a same structure to the planar power transformer 250 of the integrated system 200 shown in Fig. 4. The planar power transformer 450 comprises a primary winding 451 and a secondary winding 453, which are disposed on the primary side 411 and the secondary side 413 of the insulative layer 401 respectively. The primary winding 451 and the secondary winding 453 are respectively embedded in two layers 403, 404 of the multi-layer PCB.

The integrated system 400 may further comprise two electromagnetic shielding plates 471, 473 which are disposed on the primary and the secondary sides 411, 413 of the insulative layer 401 respectively, to cover both the planar signal transformer 430 and the planar power transformer 450. Thus the EMI during signal and/or power transmission could be eliminated. Preferably, the two electromagnetic shielding plates 471, 473 maybe embedded in two layers of the multi-layer PCB.

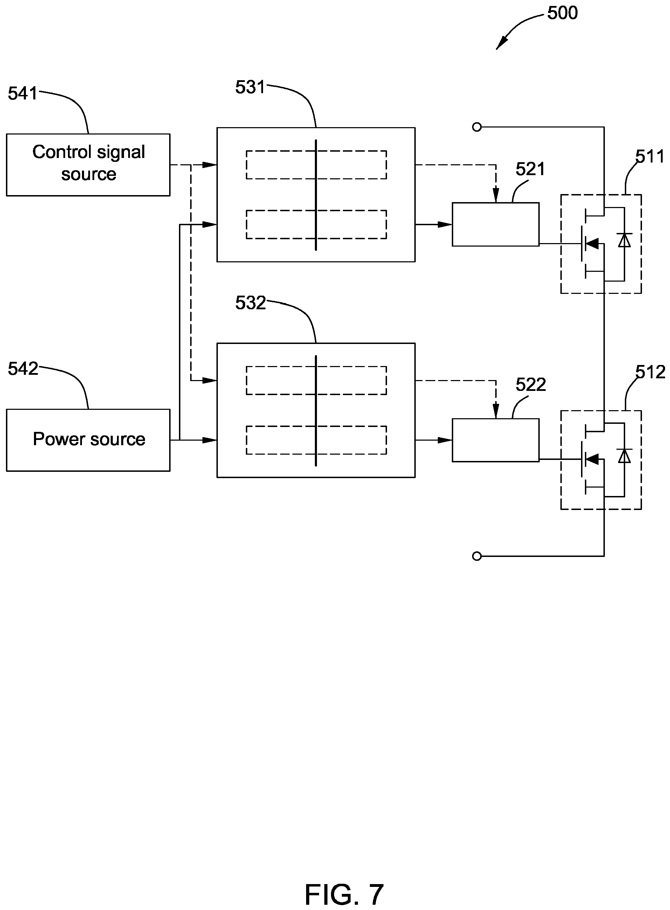

An application example of the present disclosure is shown in Fig. 7. In the application example, two integrated system 531, 532 for signal and power transmission with galvanic isolation are utilized in a power semiconductor gate driver circuit 500. The power semiconductor gate driver circuit 500 comprises a first MOSFET 511, a second MOSFET 512, a first gate driver 521, a second gate driver 522, a first integrated system 531, a second integrated system 532, a control signal source 541, and a power source 542. The first gate driver 521 and the second gate driver 522 are electrically connected to the gate electrodes of the first MOSFET 511 and the second MOSFET 512 respectively, to control on and off of the corresponding MOSFET. With the circuit 500, the signals from the control signal source 541 and the power from the power source 542 could be transferred to the first gate driver 521 and/or the second gate driver 522. At the same time, the control signal source 541 and the power source 542 are electrically isolated with the first gate driver 521 through the first integrated system 531, and electrically isolated with the second gate driver 522 through the second integrated system 532. Either the first integrated system 531 or the second integrated system 532 may comprise one of the embodiments of integrated system described above. The first integrated system 531 and the second integrated system 532 may be on two different multi-layer PCBs or on a common multi-layer PCB.

The above embodiments of the present disclosures should be illustrative, but not limited. As mentioned above, the present disclosure relates to an integrated system for signal and power transmission with galvanic isolation. The integrated system comprises an insulative layer having a primary side and a secondary side; a planar signal transformer and a planar power transformer for signal and power transmission between the primary and the secondary sides of the insulative layer respectively. The planar signal transformer comprises two signal coupling elements disposed on the primary and the secondary sides of the insulative layer respectively. The planar power transformer comprises two power coupling elements disposed on the primary and the secondary sides of the insulative layer respectively. All the coupling elements are integrated on a multi-layer PCB, that is, each of the two signal coupling elements and the two power coupling elements is embedded in at least one layer of the multi-layer PCB. In addition, the insulative layer is also embedded in one layer of the multi-layer PCB.

The two signal coupling elements may comprise a first primary winding and a first secondary winding disposed on the primary and the secondary sides of the insulative layer respectively. For example, the planar signal transformer 130 of the integrated system 100 (Fig. 1), and the planar signal transformer 230 of the integrated system 200 (Fig. 4). Otherwise, the two signal coupling elements may comprise two plate capacitors. Each of the two plate capacitors comprises two plates disposed on the primary side and the secondary side of the insulative layer respectively. For example, the planar signal transformer 330 of the integrated system 300 (Fig. 5), and the planar signal transformer 430 of the integrated system 400 (Fig. 6).

The two power coupling elements may comprise a second primary winding and a second secondary winding disposed on the primary side and the secondary side of the insulative layer respectively. The planar power transformer may further comprise two magnetic cores disposed on the primary and the secondary sides of the insulative layer respectively to cover the two power coupling elements. Usually, the two magnetic cores are made of ferrite materials. In some embodiments, the two magnetic cores may be two planar magnetic cores embedded in two different layers of the multi-layer PCB, to realize more compact structure. For example, the planar magnetic cores 255, 257 of the integrated system 200 (Fig. 4), and the planar magnetic cores 455, 457 of the integrated system 400 (Fig. 6).

All the windings of the planar power transformer and/or the planar signal transformer are made as tracks on a multilayer PCB and have a spiral shape of coils, as shown in Fig. 2 and Fig. 3.

The integrated system of the present disclosure may further comprise two electromagnetic shielding plates disposed on the primary and the secondary sides of the insulative layer respectively, to cover the planar signal transformer, as shown in Fig. 1 and Fig. 5. Furthermore, the two electromagnetic shielding plates may also cover the planar power transformer, as shown in Fig. 4 and Fig. 6. To realize more compact structure, the two electromagnetic shielding plates may be also embedded in two different layers of the multi-layer PCB. At least one of the two electromagnetic shielding plates may comprise a copper sheet for electromagnetic shielding.

This written description uses examples to describe the disclosure, including the best mode, and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. An integrated system for signal and power transmission with galvanic isolation, comprising:
an insulative layer having a primary side and a secondary side;
a planar signal transformer for signal transmission between the primary and the secondary sides of the insulative layer, comprising two signal coupling elements which are disposed on the primary and the secondary sides of the insulative layer respectively; and
a planar power transformer for power transmission between the primary and the secondary sides of the insulative layer, comprising two power coupling elements which are disposed on the primary and the secondary sides of the insulative layer respectively,
wherein each of the two signal coupling elements and the two power coupling elements is embedded in at least one layer of a multi-layer printed circuit board.

2. The integrated system of claim 1, wherein the two signal coupling elements comprise a first primary winding and a first secondary winding which are disposed on the primary and the secondary sides of the insulative layer respectively.

3. The integrated system of claim 1, wherein the two signal coupling elements comprise a primary plate capacitor and a secondary plate capacitor which are disposed on the primary and the secondary sides of the insulative layer respectively.

4. The integrated system of claim 1, wherein the two power coupling elements comprise a second primary winding and a second secondary winding which are disposed on the primary and the secondary sides of the insulative layer respectively.

5. The integrated system of claim 1, wherein the planar power transformer further comprises two magnetic cores which are disposed on the primary and the secondary sides of the insulative layer respectively to cover the two power coupling elements.

6. The integrated system of claim 5, wherein the two magnetic cores comprise two planar magnetic cores which are embedded in two different layers of the multi-layer printed circuit board.

7. The integrated system of claim 1, further comprising two electromagnetic shielding plates which are disposed on the primary and the secondary sides of the insulative layer respectively, to cover the planar signal transformer.

8. The integrated system of claim 1, further comprising two electromagnetic shielding plates which are disposed on the primary and the secondary sides of the insulative layer respectively, to cover the planar signal transformer and the planar power transformer.

9. The integrated system of any one of claims 7-8, wherein the two electromagnetic shielding plates are embedded in two different layers of the multi-layer printed circuit board.
